# EUROPEAN PATENT APPLICATION

(11) **EP 2 248 776 A1**
(43) Date of publication of application: **10.11.2010**
(21) Application number: 09709309.0
(22) Date of filing: 04.02.2009
(51) Int. Cl.: C03B 20/00, C30B 15/10, C30B 29/06

(54) **QUARTZ GLASS CRUCIBLE**

(30) Priority: 05.02.2008 JP 2008025057
(71) Applicant: Japan Super Quartz Corporation, Akita city Akita 010-0065 (JP)
(72) Inventor: KANDA, Minoru, Akita-shi Akita 010-0065 (JP)
(74) Representative: Gulde Hengelhaupt Ziebig & Schneider
(86) International application number: PCT/JP2009/051845
(87) International publication number: WO 2009/099084

(57) **Abstract**

Provided is a vitreous silica crucible which can restrain inward collapse deformation at high temperature during pulling even when the crucible has a large opening diameter. The vitreous silica crucible has an outer layer made of natural fused silica and an inner layer made of synthetic fused silica. The straight body section is outwardly-widened upwardly. Preferably, the difference in inner diameter of the lower and upper ends of the outwardly-widened section is 0.1 % or more. The inner layer made of synthetic fused silica on the corner section has a layer thickness which is 20 % to 80 % of the wall thickness of the central portion of the corner section. Preferably, the inner layer made of synthetic fused silica on the straight body section and the bottom section is thinner than that on the corner section.

## Description

### TECHNICAL FIELD

The present invention relates to a vitreous silica crucible for pulling silicon single crystals. More specifically, the present invention relates to a vitreous silica crucible which can restrain the occurrence of inward collapse deformation at high temperature during pulling even when the crucible has a large opening diameter.

### BACKGROUND ART

Silicon single crystals used as semiconductor material are primarily manufactured by pulling silicon melt contained in a vitreous silica crucible. Known is a vitreous silica crucible used for the pulling of silicon single crystals which has an inner layer made of synthetic fused silica. The inner layer is placed for the purpose of improving single crystal quality because the inner layer contacts silicon melt. Also known is a vitreous silica crucible which has an inner layer made of synthetic fused silica and an outer layer made of natural fused silica. These layers are employed in order to improve high-temperature strength of the crucible because synthetic fused silica has slightly lower high-temperature viscosity than natural fused silica (Patent Documents 1 to 3).

Furthermore, reported is a vitreous silica crucible which includes aluminum oxide or silicon nitride between an outer layer made of natural fused silica and an inner layer made of synthetic fused silica. This structure is employed to form a crystallized layer which functions as a crystallization promoter at high temperature (Patent Document 4).

Furthermore, reported is a vitreous silica crucible which includes inner and outer layers made of natural fused silica and an inner lining made of synthetic fused silica on the part ranging from the crucible bottom section to the corner section in order to restrain melt surface vibration during pulling (Patent Document 5).

On the other hand, reported is a vitreous silica crucible which has a straight body section tapered so that the section is outwardly-widened upwardly. The straight body section is thus configured to uniformize oxygen concentration in single crystal silicon (Patent Document 6). Furthermore, with regards to a crucible having an outwardly-widened upper end section, reported is a vitreous silica crucible which has an inner layer made of synthetic fused silica and a carbon outer layer. The carbon outer layer is provided to enhance crucible strength at high temperature to prevent inward collapse and buckling (Patent Document 7).
Patent Document 1: Japanese Patent Application Laid-Open No. Hei 1 (1989)-261293
Patent Document 2: Japanese Patent Application Laid-Open No. Hei 1 (1989)-275496
Patent Document 3: Japanese Patent Application Laid-Open No. Hei 03 (1991)-40989
Patent Document 4: Japanese Patent Application Laid-Open No. Hei 04(1992)-21587
Patent Document 5: International Publication WO2004/097080
Patent Document 6: Japanese Patent Application Laid-Open No. Sho 57 (1982)-38398
Patent Document 7: Japanese Patent Application Laid-Open No. 2007-076974

### DISCLOSURE OF THE INVENTION

### Problems to be Solved by the Inventions

The crucible having an inner layer made of synthetic fused silica can reduce impurities mixed in single crystal silicon and improve single crystallization rate and the crystal quality of single crystals. However, the straight body section of the crucible is likely to experience inward collapse deformation during pulling because synthetic fused silica has slightly lower high-temperature viscosity than natural fused silica. This leads to interruption of the pulling and a drop in the crystallization rate. Especially, when a crucible has a large opening diameter, this problem tends to occur, because the wall temperature during use becomes higher as the crucible size is larger (Patent Document 1 to 3). This is true of a crucible having an inner lining made of synthetic fused silica on the part ranging from the crucible bottom section to the corner section (Patent Document 5)

On the other hand, while a vitreous silica crucible including aluminum oxide or silicon nitride, as a crystallization promoter, between a natural fused silica layer and a synthetic fused silica layer is strengthened due to the formation of a crystallized layer, the obtained strength is still insufficient to surely prevent inward collapse, and that insufficiency is especially serious for a large-size crucible. Besides, difference in thermal expansion between the crystallized layer and the vitreous silica layer tends to cause peeling or crack, which leads to leakage of silicon melt during pulling (Patent Document 4).

Furthermore, a vitreous silica crucible tapered so as to be outwardly-widened upwardly can prevent inward collapse because the upper end of the crucible mounted in a susceptor tends to decline toward the outer susceptor (Patent Document 6). However, even when the straight body section of the crucible has a shape outwardly-widened upwardly, the corner section of the crucible can gradually lower down to the susceptor in case there exists a gap between the corner section of the crucible and the susceptor. The deformation caused by the lowering changes the direction of the straight body section so that the straight body section becomes in a vertical direction or slightly inwardly-tilted, which can result in inward collapse. Furthermore, the deformation during pulling can cause dislocations and ununiformity.

Furthermore, a crucible having an outwardly-widened upper end section and a carbon outer layer requires complex manufacturing process because of the two-tier structure, and the processing and handling is burdensome. Especially, it is very difficult to maintain the purity level of the vitreous silica inner layer by restraining the mix-in of carbon particles from the outer surface carbon layer to the inner surface vitreous silica layer (Patent Document 7).

### Means for Solving the Problems

In order to solve the above-mentioned problems, the present invention provides a vitreous silica crucible comprising: an outer layer made of natural fused silica; and an inner layer made of synthetic fused silica, wherein the crucible comprises a straight body section, a corner section, and a bottom section, and the straight body section is outwardly-widened upwardly, the inner layer on the corner section has a layer thickness which is 20 % to 80 % of the wall thickness of a central portion of the corner section, and the inner layer on the straight body section and the bottom section is thinner than that on the corner section.

According to the present invention, because the straight body section is outwardly-widened upwardly, inward collapse at high temperature does not occur. In addition, because the inner layer made of synthetic fused silica on the corner has a maximum layer thickness which is 20 % or more of the maximum wall thickness of the corner section, the corner section of the crucible mounted on a susceptor can be in close contact with the susceptor. Furthermore, because the inner layer has a maximum layer thickness which is 80 % or less of the maximum wall thickness of the corner section and the inner layer on the straight body section and the bottom section is thinner than that on the corner section, the corner section maintain sufficient strength at high temperature and the straight body section and the bottom section have sufficient strength, and therefore, deformation due to the lowering etc. does not occur. Therefore, single crystal can be pulled efficiently even when a large-size crucible is used.

In the present invention, the difference in inner diameter of the lower and upper ends of the straight body section which is outwardly-widened upwardly is preferably 0.1 % or more. When the difference in inner diameter of the lower and upper ends of the outwardly-widened section is 0.1% or more, inward collapse of the crucible is surely prevented because the upper end section of the crucible is provided with a large outwardly-directed force.

In the present invention, the range from the upper end of the straight body section to the corner section may be outwardly-widened upwardly. Alternatively, the range within 50mm from the upper end of the straight body section may be a vertical section, and the range from the lower end of the vertical section to the corner section may be outwardly-widened upwardly. In either case, the difference in inner diameter of the lower and upper ends of the outwardly-widened section is preferably 0.1 % or more. In either case, when the straight body section is viewed as a whole, the straight body section is outwardly-widened upwardly. Therefore, the upper end section of the crucible receives a large outwardly-directed force, and thus the inward collapse of the crucible is surely prevented.

In the present invention, the wall thickness of the straight body section is preferably thinned toward the upper end section. When the wall thickness of the straight body section is thinned toward the upper end section, the upper end section of the straight body section becomes lighter than the lower section, and the possibility of inward collapse is further reduced.

### EFFECT OF THE INVENTION

According to the present invention, provided is a vitreous silica crucible which can restrain deformation caused by inward collapse, lowering, etc. at high temperature during pulling even when the crucible has a large opening diameter.

### BRIEF DESCRIPTION OF THE DRAWINGS

Fig. 1 is a schematic sectional view illustrating a structure of a vitreous silica crucible according to a first embodiment of the present invention.
Fig. 2 is a schematic sectional view illustrating a structure of a vitreous silica crucible according to a second embodiment of the present invention.

### EXPLANATION OF REFERENCE SYMBOLS

10-vitreous silica crucible, 11-straight body section, 11a- upper end of straight body section, 11b-lower end of straight body section, 11 c- lower end of vertical section of straight body section, 12-corner section, 13-bottom section, 20-outer layer, 21-inner layer, 30-vitreous silica crucible

### BEST EMBODIMENT FOR CARRYING OUT THE INVENTION

Hereinafter, the present invention will be explained in detail based on embodiments with reference to attached drawings.

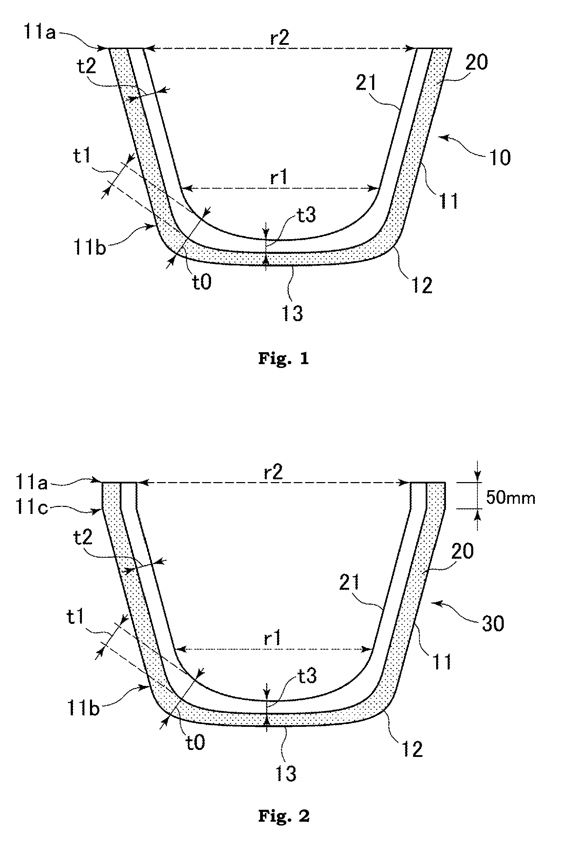

Fig. 1 is a schematic sectional view illustrating a structure of a vitreous silica crucible according to a first embodiment of the present invention.

As shown in Fig. 1, a vitreous silica crucible 10 according to the present embodiment is for pulling of silicon single crystal. The vitreous silica crucible 10 has an outer layer 20 made of natural fused silica and an inner layer 21 made of synthetic fused silica. Natural fused silica means vitreous silica manufactured by melting natural material such as natural quartz crystal, silica stone, and so on. In general, natural quartz contains metal impurities at higher concentration and OH groups at lower concentration than synthetic silica. For example, natural quartz contains an Al content of 1 ppm or more, each alkali metal (Na , K and Li) content of 0.05ppm or more, and an OH group content of less than 60 ppm. On the other hand, synthetic fused silica means vitreous silica manufactured by melting synthetic material produced, for example, by hydrolysis of silicon alkoxide. In general, synthetic silica contains metal impurities at lower concentration and OH groups at higher concentration than natural quartz. For example, synthetic silica contains each metal impurities (Al, Na , K, Li, etc.) content of less than 0.05ppm, and an OH group content of 30 ppm or more. However, it should be noted that because synthetic silica with metal impurities such as Al added to is known, whether vitreous silica at issue is made of synthetic silica or natural quartz should not be judged based on a single factor, but should be comprehensively judged based on a plurality of factors

As shown in the drawings, a vitreous silica crucible 10 includes a straight body section 11 forming an upstanding sidewall section, a corner section 12 which is curved and continues from the lower end of the straight body section 11, and a bottom section 13 which is relatively flat and continues from the corner section 12. The straight body section 11 is outwardly-widened upwardly, and thus the crucible 10 has a bowl shape. Here, the boundary between the straight body section 11 and the corner section 12 is a point where the tangential tilt angle of the crucible wall, which is constant on the straight body section 11, starts to change. The boundary between the corner section 12 and the bottom section 13 varies dependent on whether the bottom section is a round bottom or a flat bottom. In the present invention, the boundary does not need to be clearly defined. But, as an example, the region where the tangential tilt angle of the wall surface with respect to the XY plane orthogonally crossing the central axis (Z axis) of the crucible is 10 degrees or more is defined as the corner section 12, and the region where the tangential tilt angle is less than 10 degrees is defined as the bottom section 13.

The vitreous silica crucible 10 according to the present embodiment has an outer section (outer layer) 20 which extends from the straight body section 11 to the corner section 12 and the bottom section 13, i.e. extends over the entire crucible 10. The outer section (outer layer) 20 is made of natural fused silica. Therefore, the crucible 10 has larger strength at high temperature and is hard to deform than a crucible totally made of synthetic fused silica.

The vitreous silica crucible 10 according to the present embodiment has an inner section (inner layer) 21 which extends from the straight body section 11 to the corner section 12 and the bottom section 13, i.e. extends over the entire crucible 10. The inner section (inner layer) 21 is made of synthetic fused silica. Because the inner layer 21 which contacts silicon melt is made of a highly-pure synthetic fused silica layer, pulled silicon single crystal contains extremely low impurity concentration. The inner layer 21 made of synthetic fused silica on the straight body section 11 and the bottom section 13 (thus not on the corner section 12) has a layer thickness of about 5 % to 50% of the wall thickness of the straight body section 11 and the bottom section 13, respectively.

Furthermore, in the vitreous silica crucible 10, the inner layer 21 made of synthetic fused silica on the corner section 12 has a maximum layer thickness t1 which is 20 % to 80 % of the maximum wall thickness t0 in the same location. The maximum thickness t1 of the inner layer 21 on the corner section 12 is larger than the layer thicknesses t2, t3 of the inner layer 21 on the straight body section 11 and the bottom section 13, respectively. The inner layer 21 on the straight body section 11 and the bottom section 13 is thinner than the inner layer 21 on the corner section 12.

In the vitreous silica crucible 10, the maximum layer thickness t1 on the corner section 12 is 20% or more of the wall thickness t0 of the corner section 12, and is larger than the maximum layer thicknesses t2 , t3 of the inner layer 21 made of synthetic fused silica on the straight body section 11 and the bottom section 13, respectively. Therefore, when the crucible is mounted in a susceptor and used for pulling, the corner section 12 of the crucible is, at high temperature during pulling, softened slightly more easily than the straight body section 11. Therefore, when melting silicon before pulling, the corner section 12 becomes in close contact with the susceptor, and the crucible is stably supported in the susceptor. Furthermore, because the straight body section 11 is outwardly-widened and is provided with a outward force, inward collapse of the straight body section 11 does not occur.

When the layer thickness of the inner layer 21 on the corner section 12 is less than 20%, the corner section 12 of the crucible is, at high temperature when melting silicon, not easily softened, the corner section 12 does not become in close contact with the susceptor, and thus a gap between the corner section 12 and the susceptor remains. When pulling is continued, the gap can cause the deformation of the entire crucible. Therefore, such layer thickness is not preferred. The deformation of the entire crucible changes the direction of the straight body section, which is initially outwardly-widened, so that the straight body section becomes in a vertical direction or slightly inwardly-tilted, which can finally result in inward collapse.

In the vitreous silica crucible 10, the maximum layer thickness t1 of the inner layer 21 on the corner section 12 is 80 % or less of the wall thickness t0 of the corner section 12. When the layer thickness of the inner layer made of synthetic fused silica is larger than 80 %, the corner section is easy to be softened and thus vulnerable to the lowering. Therefore, such layer thickness is not preferable. Furthermore, because the inner layer 21 made of synthetic fused silica on the straight body section 11 and the bottom section 13 has a thinner thickness than the inner layer 21 made of synthetic fused silica on the corner section 12, the straight body section 11 and the bottom section 13 are hard to be softened and therefore the deformation is hard to occur.

In the vitreous silica crucible 10, the straight body section 11 is outwardly-widened upwardly. Therefore, the straight body section 11 receives an outward force, and therefore the inward collapse can be prevented even when the crucible is slightly softened at high temperature during pulling.

In the vitreous silica crucible 10, the range from the upper end 11a of the straight body section 11 to the corner section 12 is outwardly-widened upwardly. It is preferred that the difference in inner diameter between the lower end 11b and the upper end 11a of the straight body section 11 is 0.1 % or more, that is, the inner diameter of the upper end 11a is 1.001r1 or more of the inner diameter of the lower end 11b. When the difference in inner diameter of the straight body section 11 is less than 0.1%, the outward tilt is small and therefore inward collapse can occur depending on the softened state of the straight body section 11. In the above-mentioned outwardly-widened shape, the outer diameter may be formed so as to be outwardly-widened in accordance with the tilt of the outwardly-widened shape of the inner diameter. It should be noted that when the difference in inner diameter between the lower end 11b and the upper end 11a of the straight body section 11 is 0.1 % or more, the outer diameter of the straight body section 11 may be constant from the lower end to the upper end.

The wall thickness containing the inner layer 21 and the outer layer 20 of the straight body section 11 of the crucible is preferably thinned toward the upper end section 11a. With this shape, the upper end section of the straight body section of the crucible becomes lighter than the lower section, and the possibility of inward collapse is further reduced.

As explained above, the vitreous silica crucible 10 according to the present embodiment becomes in close contact with an outer carbon susceptor when melting silicon contained in the crucible for pulling of silicon single crystals, and therefore the deformation of the crucible can be restrained from the beginning of the pulling. Because the deformation does not occur during the pulling, the dislocation occurrence rate is low and the ununiformity of the crystal quality decreases. Furthermore, even when the shape of the carbon susceptor is slightly changed due to the consumption thereof during the pulling, the change is absorbed by the softening of the corner section and therefore the crucible becomes in close contact with the susceptor, and the single crystallization rate is enhanced.

Fig. 2 is a schematic sectional view illustrating a structure of a vitreous silica crucible according to a second embodiment of the present invention.

As shown in Fig. 2, in the vitreous silica crucible 30 according to the present embodiment, the range within 50mm from the upper end 11a of the straight body section 11 is not outwardly-widened, but vertical, and the range from the lower end 11c of the vertical section to the corner section 12 is outwardly-widened upwardly. When the vertical section is in a range of 50mm or less from the upper end 11a of the straight body section 11, the upper end section of the straight body section 11 is unlikely to collapse inwardly even when the opening diameter (inner diameter) of the vertical section is constant. Therefore, the range other than the range of 50mm or less from the upper end 11a of the straight body section 11 may be outwardly-widened.

As to the straight body section 11, it is preferred that the difference in inner diameter between the lower end 11b and the upper end 11a (11c) is 0.1% or more, that is, the inner diameter of the upper end 11a (11c) is larger, by 0.1 % or more, than the inner diameter of the lower end 11b. When the difference in inner diameter of the straight body section 11 is less than 0.1%, the outward tilt is small and therefore inward collapse can occur depending on the softened state of the straight body section 11. Other configurations are substantially the same as those in a vitreous silica crucible according to the first embodiment, corresponding components are given corresponding reference symbols, and the detailed explanation is not repeated.

As explained above, similar to the above-mentioned vitreous silica crucible 10, the vitreous silica crucible 30 according to the present embodiment becomes in close contact with an outer carbon susceptor when melting silicon contained in the crucible for pulling of silicon single crystals, and therefore the deformation of the crucible can be restrained from the beginning of the pulling. Because the deformation does not occur during the pulling, the dislocation occurrence rate is low and the ununiformity of the crystal quality decreases. Furthermore, even when the shape of the carbon susceptor is slightly changed due to the consumption thereof during the pulling, the change is absorbed by the softening of the corner section and therefore the crucible becomes in close contact with the susceptor, and the single crystallization rate is enhanced.

### EXAMPLES

Natural quartz powder was deposited on the inner surface of a rotating carbon mold, and then synthetic silica powder was deposited thereon, followed by arc melting to produce a vitreous silica crucible. The inner surface of the carbon mold was outwardly-widened upwardly. The natural quartz powder and the synthetic silica powder were deposited so that the upper and lower end sections of the straight body section and the corner section had a wall thickness as listed in Table 1 and the inner layer of the synthetic fused silica layer had a layer thickness as listed in Table 1 to manufacture vitreous silica crucible samples No. 1 to No. 6 with an opening diameter of about 24 inches. The size of each vitreous silica crucible had a height of 50 cm, and a height from the lower end to the upper end of the straight body section (the upper end of the crucible) of 35 cm. Next, silicon single crystals were pulled using these crucible samples No.1 to No.6. The result is shown in Table 1.

As shown in Table 1, as to Samples Nos. 1 to 3 where the difference in inner diameter of the upper end and the lower end of the straight body section was 0.1 % or more, and the thickness of the synthetic fused silica layer on the central portion of the corner section was 20% to 80 % of the wall thickness, the corner section was softened and became in close contact with the susceptor, and the deformation of the crucible did not occur during the pulling, and the pulling result was good.

On the other hand, as to Sample No. 4 where the maximum layer thickness of the inner layer (the synthetic layer) was more than 80 % of the wall thickness on the corner section, partial buckling occurred on the corner section and the pulling result was poor. Furthermore, as to Sample No. 5 where the difference in opening diameter of the upper end and the lower end of the straight body section was less than 0.1 %, inward collapse occurred on the upper end section of the crucible and the pulling result was poor. Furthermore, as to Sample No. 6 where the maximum layer thickness of the inner layer (the synthetic layer) was less than 20 % of the wall thickness on the corner section, the pulling result was poor because the corner section of the crucible was not in close contact with the susceptor.

**[Table 1]**

| No. | opening diameter (inner diameter) | | | wall thickness | | | synthetic layer thickness | | | | pulling result | deformation state |
|---|---|---|---|---|---|---|---|---|---|---|---|---|
| | straight body section upper end | straight body section lower end | difference in inner diameter | straight body section upper end | straight body section lower end | center of the corner section | straight body section upper end | straight body section lower end | center of the corner section | ratio of synthetic layer | | |
| | mm | mm | % | mm | mm | mm | mm | mm | mm | % | | |
| 1 | 588 | 587.3 | 0.11 | 11 | 11 | 17.1 | 3 | 3.2 | 4 | 23.3 | Good | no deformation, fit with susceptor |
| 2 | 588 | 585.3 | 0.46 | 11 | 11.1 | 17.5 | 3.1 | 5.4 | 13.8 | 78.8 | Good | same as above |
| 3 | 591.4 | 584.8 | 1.12 | 9.8 | 11.5 | 18 | 3 | 4.3 | 9 | 50 | Excellent | same as above |
| 4 | 588 | 586 | 0.34 | 11 | 11 | 17.5 | 3.1 | 5.1 | 15.5 | 88.57 | Poor | partial buckling on the corner |
| 5 | 588 | 587.5 | 0.08 | 11 | 11 | 17.3 | 3 | 4.1 | 8 | 46.24 | Poor | inward collapse on the upper end |
| 6 | 588 | 586 | 0.34 | 11 | 11 | 16.8 | 2.5 | 2.6 | 3 | 17.85 | Poor | contact failure to susceptor when melting |

| | | | | | | | | | | | | |
|---|---|---|---|---|---|---|---|---|---|---|---|---|
| Note: Ratio of synthetic layer on the column of "synthetic layer thickness" is measured at the center of the corner section. Nos. 1 to 3 are examples of the present invention, and Nos. 4 to 6 are examples outside of the preferred range of the present invention. | | | | | | | | | | | | |

## Claims

1. A vitreous silica crucible comprising:
an outer layer made of natural fused silica; and
an inner layer made of synthetic fused silica, wherein
the crucible comprises a straight body section, a corner section, and a bottom section, and the straight body section is outwardly-widened upwardly, the inner layer on the corner section has a layer thickness which is 20 % to 80 % of the wall thickness of a central portion of the corner section, and the inner layer on the straight body section and the bottom section is thinner than that on the corner section.

2. The vitreous silica crucible of claim 1, wherein a difference in inner diameter of the lower and upper ends is 0.1 % or more.

3. The vitreous silica crucible of claim 1, wherein a range from an upper end of the straight body section to the corner section is outwardly-widened upwardly.

4. The vitreous silica crucible of claim 1, wherein a range within 50mm from an upper end of the straight body section is a vertical section, and a range from a lower end of the vertical section to the corner section is outwardly-widened upwardly.

5. The vitreous silica crucible of claim 1, wherein a wall thickness of the straight body section is thinned toward an upper end section thereof.
